# EUROPEAN PATENT APPLICATION

(11) **EP 2 645 412 A1**
(43) Date of publication of application: **02.10.2013**
(21) Application number: 10860013.1
(22) Date of filing: 24.11.2010
(51) Int. Cl.: H01L 23/473, H01L 23/40, H02M 7/48, H05K 7/20

(54) **STACKED COOLER**

(71) Applicant: Toyota Jidosha Kabushiki Kaisha, Toyota-shi, Aichi 471-8571 (JP)
(72) Inventor: MIYAMOTO, Shingo, Toyota-shi Aichi 471-8571 (JP); KITAMI, Akio, Toyota-shi Aichi 471-8571 (JP)
(74) Representative: Intès, Didier Gérard André
(86) International application number: PCT/JP2010/070938
(87) International publication number: WO 2012/070129

(57) **Abstract**

A stacked cooler 24 includes a plurality of refrigerant flow passages 26 and a plurality of semiconductor modules 20 and 22. The refrigerant flow passages 26 and the semiconductor modules 20 and 22 are stacked alternately, and each of opposite surfaces in a stacking direction of each of the semiconductor modules 20 and 22 is in contact with a corresponding one of the refrigerant flow passages 26, thereby cooling the semiconductor modules 20 and 22. The semiconductor modules 20 and 22 generate different amounts of heat. One or a plurality of the semiconductor modules 20 and one or a plurality of the semiconductor module 22 are arranged in each of arrangement spaces adjacent to the refrigerant flow passages 26 so that a difference in amount of heat generated between the respective arrangement spaces becomes small. Consequently, cooling capability is equalized throughout the respective arrangement spaces, enabling reduction in waste due to excessive cooling.

## Description

### TECHNICAL FIELD

The present invention generally relates to an improvement of a structure of a stacked cooler that cools an electronic component from opposite sides of the electronic component.

### BACKGROUND ART

Conventionally, there are known stacked coolers that bring a refrigerant flow passage allowing a refrigerant to flow therein into contact with each of opposite surfaces of an electronic component, which is a heat generator, to cool the electronic component.

Patent Literature 1, which is indicated below, describes a structure that cools an inverter device supplying power to a motor that drives an automobile. The inverter device includes six semiconductor modules. The cooling structure in the Patent Literature includes six cooling tubes, each allowing a refrigerant to flow therein, arranged in a stacking direction in contact with opposite surfaces of the respective semiconductor modules.

Patent Literature 2, which is indicated below, describes a stacked cooler including a plurality of refrigerant flow passages allowing a refrigerant to flow therein and a plurality of semiconductor modules, the refrigerant flow passages and the semiconductor modules being stacked alternately. In the stacked cooler, also, the respective refrigerant flow passages are provided so as to be in contact with opposite surfaces in a stacking direction of the semiconductor modules. In the stacked cooler, the semiconductor modules are classified into semiconductor module groups that control respective devices to be controlled. Arrangement is made so that semiconductor modules belonging to a semiconductor module group that generates a largest amount of heat, from among the semiconductor module groups, are not adjacent to each other in the stacking direction across a certain refrigerant flow passage. Such arrangement prevents a distribution of generated heat in the stacked cooler from being biased because of the generated heat amounts differing depending on the respective semiconductor modules, thereby preventing each semiconductor module from having a temperature exceeding its allowable temperature.

### CITATION LIST

### PATENT LITERATURE

Patent Literature 1: Japanese Patent Laid-Open Publication No. 2002-26215
Patent Literature 2: Japanese Patent Laid-Open Publication No. 2007-266634

### SUMMARY OF INVENTION

### TECHNICAL PROBLEM

For automobiles including an internal-combustion engine and a rotating electrical machine as a prime mover; i.e., so-called hybrid vehicles, there are examples in which two rotating electrical machines having different output characteristics are used. In such cases, power modules; that is, semiconductor module groups, corresponding to the respective rotating electrical machines generate different amounts of heat. Therefore, a stacked cooler included in a hybrid vehicle is configured so as to have a cooling capability for the semiconductor modules belonging to a semiconductor module group that generate the largest amount of heat, in order to cool the plurality of semiconductor module groups. However, such cooling capability is excessive for semiconductor modules belonging to a semiconductor module group that generate a small amount of heat. In other words, there is a problem in that the stacked cooler has excessive capability.

As in the stacked cooler in Patent Literature 2 described above, there may be employed a method of dispersing semiconductor modules belonging to a semiconductor module group that generate the largest amount of heat. However, the dispersed arrangement causes problems such as complication of electrical connection to the respective devices to be controlled, and increase in size of the body of the stacked cooler or failure to respond to size reduction.

An advantage of the present invention lies in provision of a stacked cooler enabling optimization of cooling capability and reduction in size of the body, with a simple configuration.

### SOLUTION TO PROBLEM

The present invention provides a stacked cooler including a plurality of refrigerant flow passages allowing a refrigerant to flow therein and a plurality of electronic components, the refrigerant flow passages and the electronic components being stacked alternately, a stacking surface in a stacking direction of each of the electronic components being in contact with a corresponding one of the refrigerant flow passages, thereby cooling the electronic components, wherein the electronic components include a plurality of electronic components that generate different amounts of heat; and wherein one or a plurality of the electronic components are arranged in each of arrangement spaces adjacent to the respective refrigerant flow passages so that a difference in total amount of heat generated by the one or the plurality of the electronic components between the respective arrangement spaces becomes small.

Furthermore, preferably: each electronic component includes a semiconductor module including at least one semiconductor device that is a heat generator; and one or a plurality of the semiconductor modules are arranged in each of the arrangement spaces so that the difference in the total amount of heat generated becomes small.

Furthermore, preferably, the one or the plurality of the semiconductor modules arranged in each of the arrangement spaces include a number of semiconductor devices corresponding to the total amount of heat generated.

Furthermore, the electronic components may include an end-portion electronic component arranged between a housing that houses a body of the stacked cooler, and a refrigerant flow passage positioned at an end portion in the stacking direction; and one stacking surface in the stacking direction of the end-portion electronic component may be in contact with the refrigerant flow passage, and another stacking surface of the end-portion electronic component may be in contact with the housing, thereby cooling the end-portion electronic component.

Furthermore, the end-portion electronic component may include a number of semiconductor devices, the number being larger than that of another of the electronic components.

Furthermore, preferably, the end-portion electronic component, when projected in the stacking direction, is larger than the other electronic component.

Furthermore, the end-portion electronic component, when projected in the stacking direction, is preferably smaller than a refrigerant flow passage.

Furthermore, the total amount of heat generated by the end-portion electronic component is preferably smaller than the total amount of heat generated by the other electronic component.

### ADVANTAGEOUS EFFECTS OF INVENTION

The stacked cooler according to the present invention enables optimization of cooling capability and reduction in size of the body, with a simple configuration.

### BRIEF DESCRIPTION OF THE DRAWINGS

[FIG. 1] FIG. 1 is a diagram illustrating a schematic configuration of a hybrid vehicle including a stacked cooler according to an embodiment of the invention.
[FIG. 2] FIG. 2 is an exploded perspective diagram of the stacked cooler according to the present embodiment.
[FIG. 3] FIG. 3 is a sectional view of the stacked cooler along line A-A in FIG. 2.
[FIG. 4] FIG. 4 is an exploded perspective diagram of a stacked cooler according to another embodiment.
[FIG. 5] FIG. 5 is a sectional view of the stacked cooler along line B-B in FIG. 4.

### DESCRIPTION OF EMBODIMENTS

Embodiments of a stacked cooler according to the present invention will be described below by reference to the drawings. Taking an inverter, which is a power module that supplies power to a rotating electrical machine that drives an automobile, as an example, a stacked cooler that cools such an inverter will be described. The present invention is applicable not only to the aforementioned power module, but also to a stacked cooler that cools an electronic component that is a heat generator.

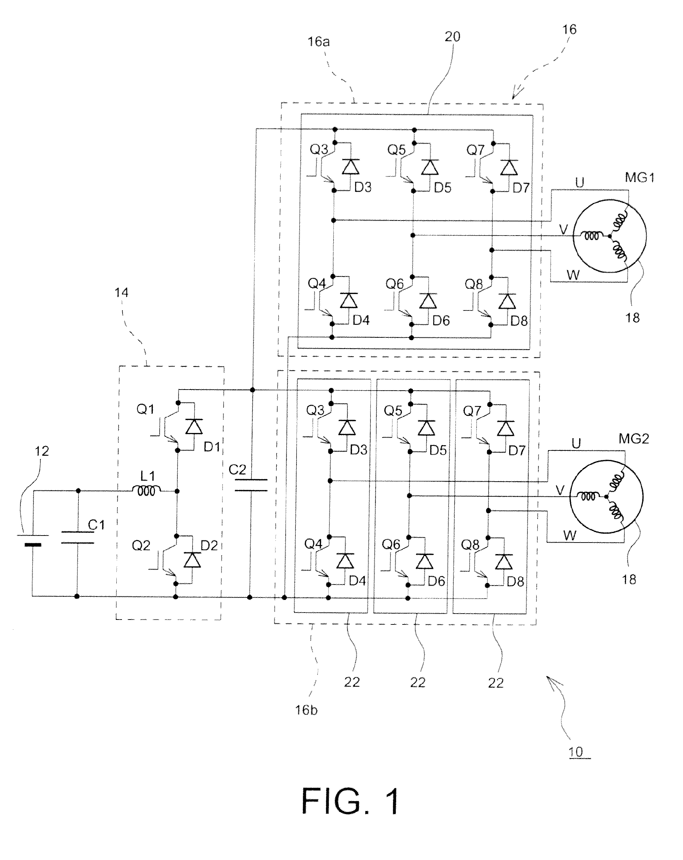

FIG. 1 is a diagram illustrating a schematic configuration of a hybrid vehicle (hereinafter simply referred to as "vehicle") including a stacked cooler according to the present embodiment.

A vehicle 10 includes a battery 12, a converter 14, inverters 16, and rotating electrical machines 18.

The battery 12 includes a chargeable/dischargeable secondary battery, such as a nickel-hydrogen secondary battery, a lithium-ion secondary battery, or the like. The battery 12 includes a plurality of modules each including a plurality of cells connected in series, and the modules are further connected in series. In other words, in the battery 12, all the cells included in the serially-connected modules are connected in series. Consequently, the battery 12 ensures a high voltage necessary for driving the vehicle 10. Alternatively, the battery 12 may be a large-volume capacitor.

The converter 14 is a device including a reactor, and switching elements that are semiconductor devices, in which energy is repeatedly stored/released into,/from the reactor via switching operation of switching elements to convert an input voltage to obtain an output voltage. In FIG. 1, the converter 14 is a bidirectional DC/DC converter that steps direct-current power up and down.

More specifically, in FIG. 1, the converter 14 includes a reactor L1, switching elements Q1 and Q2, and diodes D1 and D2. The switching elements Q1 and Q2 each include, e.g., an IGBT (insulated gate bipolar transistor), a power transistor, or a thyristor. The switching elements Q1 and Q2 are connected in series between a power supply line and a ground line for the inverter 16. A collector of the switching element Q1 at an upper arm is connected to the power supply line, and an emitter of the switching element Q2 at a lower arm is connected to the ground line. An intermediate point between the switching elements Q1 and Q2; that is, a point of connection between an emitter of the switching element Q1 and a collector of the switching element Q2, is connected to an end of the reactor L1. The other end of the reactor L1 is connected to a positive electrode of the battery 12. Also, the emitter of the switching element Q2 is connected to a negative electrode of the battery 12. Furthermore, the diodes D1 and D2 are arranged between the collectors and the emitters of the respective switching elements Q1 and Q2 so that a current flows from the emitter side to the collector side.

A smoothing capacitor C1 is connected between the other end of the reactor L1 and the ground line. Also, a smoothing capacitor C2 is connected between the collector of the switching element Q1 and the ground line. Each of the capacitors C1 and C2 may be an electrolytic capacitor or a film capacitor. The capacitor C1 smoothes a direct-current voltage supplied from the battery 12, and supplies the smoothed direct-current voltage to the converter 14. Meanwhile, the capacitor C2 smoothes a direct-current voltage from the converter 14, and supplies the smoothed direct-current voltage to the inverters 16.

One side of each of the inverters 16 is connected to the converter 14 and the other side of the same is connected to the respective rotating electrical machine 18. The rotating electrical machines 18 are three-phase permanent magnetic motors. Configurations of the inverters 16 and the rotating electrical machines 18 will be described below.

The inverters 16 each include respective arms of a U-phase, a V-phase and a W-phase, which are arranged in parallel between the power supply line and the ground line. The U-phase includes serial connection of switching elements Q3 and Q4, the V-phase includes serial connection of switching elements Q5 and Q6, and the W-phase includes serial connection of switching elements Q7 and Q8. Each of the switching elements Q3 to Q8 may include an IGBT, a power transistor, a thyristor, or the like. Diodes D3 to D8 that make a current flow from the emitter side to the collector side are arranged between collectors and emitters of the respective switching elements Q3 to Q8.

Intermediate points of the arms of the respective phases are connected to respective-phase ends of respective-phase coils in the respective rotating electrical machines 18. More specifically, an intermediate point between the switching elements Q3 and Q4 at the U-phase arm; that is, a point of connection between the emitter of the switching element Q3 and the collector of the switching element Q4, is connected to an end of a U-phase coil in the respective rotating electrical machine 18. Also, an intermediate point between the switching elements Q5 and Q6 at the V-phase arm; that is, a point of connection between the emitter of the switching element Q5 and the collector of the switching element Q6, is connected to an end of a V-phase coil in the respective rotating electrical machine 18. Also, an intermediate point between the switching elements Q7 and Q8 at the W-phase arm; that is, a point of connection between the emitter of the switching element Q7 and the collector of the switching element Q8, is connected to an end of a W-phase coil in the respective rotating electrical machine 18. Each rotating electrical machine 18 includes a neutral point connected in common to the other ends of the coils of the respective phases.

Upon supply of direct-current power from the converter 14 to the inverters 16 via the capacitor C2, the inverters 16 convert the direct-current power to alternating-current power to drive the respective rotating electrical machines 18. Also, during regenerative braking of the vehicle 10, the inverters 16 convert alternating-current power generated by the rotating electrical machines 18 to direct-current power, and supply the direct-current power resulting from the conversion to the converter 14 via the capacitor C2.

As illustrated in FIG. 1, the vehicle 10 according to the present embodiment includes two rotating electrical machines 18. These rotating electrical machine 18 have different output characteristics. The rotating electrical machine 18 having a small output characteristic is simply referred to as MG1 below. Meanwhile, hereinafter, the rotating electrical machine 18 having a large output characteristic is simply referred to as MG2. Furthermore, the inverter 16 for MG1 is referred to as a first inverter 16a and the inverter 16 for MG2 is referred to as a second inverter 16b below.

As described above, the output characteristic of MG2 is larger than the output characteristic of MG1. Accordingly, an amount of heat generated by the second inverter 16b is larger than an amount of heat generated by the first inverter 16a, and thus, naturally, an amount of heat generated per switching element in the second inverter 16b is larger than that of the first inverter 16a. Here, an amount of heat generated refers to an amount of heat generated (W) per unit time.

The first inverter 16a includes one semiconductor module 20, which is a 6-in-1 module; that is, one including arms of three phases molded from a resin. The semiconductor module 20 includes six switching elements inside. Meanwhile, the second inverter 16b includes three semiconductor modules 22, which are 2-in-1 modules; that is, ones each including an arm of one phase molded from a resin. The semiconductor modules 22 each include two switching elements inside. In the present embodiment, an amount of heat generated by the 2-in-1 semiconductor modules 22 is larger than an amount of heat generated by the 6-in-1 semiconductor module 20. The present invention is not limited to the above configuration, and the amount of heat generated by the semiconductor modules 22 may be smaller than the amount of heat generated by the semiconductor module 20.

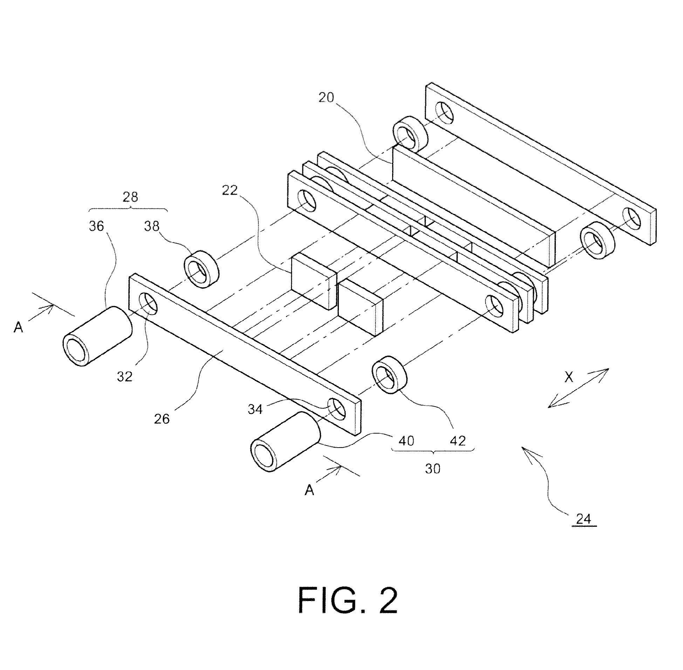

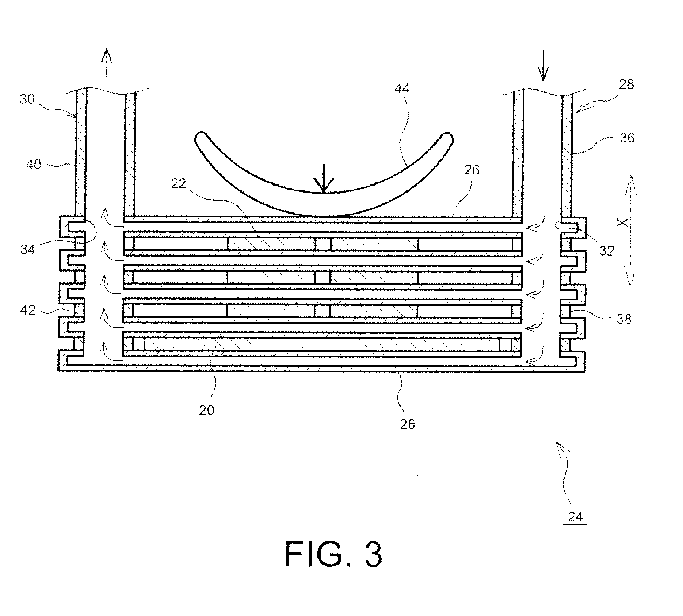

Next, a stacked cooler 24 according to the present embodiment will be described by reference to FIGS. 2 and 3. FIG. 2 is an exploded perspective diagram of a stacked cooler 24 according to the present embodiment, and FIG. 3 is a sectional view of the stacked cooler 24 along line A-A in FIG. 1. Here, the X-axis indicated in the Figure is a stacking direction in which the semiconductor modules 20 and 22 and refrigerant flow passages, which will be described later, are stacked.

The stacked cooler 24 is a device including a plurality of refrigerant flow passages 26 allowing a refrigerant to flow therein and a plurality of electronic components, the refrigerant flow passages 26 and the electronic components being stacked alternately, in which a stacking surface in a stacking direction of each of the electronic components is in contact with a corresponding one of the refrigerant flow passages, thereby cooling the electronic components. The electronic components in the present embodiment are the semiconductor modules 20 and 22.

The stacked cooler 24 includes a supply header portion 28 that supplies a refrigerant to the respective refrigerant flow passages 26, and a discharge header portion 30 that discharges the refrigerant from the respective refrigerant flow passages 26. The refrigerant in the present embodiment is an LLC (long life coolant), but the present invention is not limited to such a configuration, and any known refrigerant can be used.

The semiconductor modules 20 and 22 each have a shape of a rectangular plate squashed in the stacking direction. As described above, the semiconductor module 20 in the present embodiment is a 6-in-1 module, and includes six switching elements. As illustrated in FIGS. 2 and 3, the semiconductor module 20 is positioned at an end portion in the stacking direction. Meanwhile, as described above, the semiconductor modules 22 in the present embodiment are 2-in-1 modules, and each includes two switching elements. As illustrated in FIGS. 2 and 3, the semiconductor modules 22 are arranged in three lines in a direction from the semiconductor module 20 toward one side in the stacking direction. Although for ease of illustration, FIGS. 1 and 2 look as if two semiconductor modules 22 are arranged in one line, one 2-in-1 module is arranged in one line. Also, the counts of the semiconductor modules 20 and 22 are mere examples; the count of the semiconductor module 20 and the count of the semiconductor modules 22 in the present invention are not limited to one and three, respectively. Furthermore, the count of switching elements, which are heat generators, included in each of the semiconductor modules 20 and 22 is also a mere example, and the count of the switching elements in the semiconductor module 20 and the count of switching elements in each of the semiconductor modules 22 in the present invention are not limited to six and two.

The refrigerant flow passages 26 are made of aluminum. The refrigerant flow passage 26 has a shape of a rectangular tube squashed in the stacking direction. A total of five refrigerant flow passages 26 are arranged in the stacking direction. An inlet 32 from which a refrigerant flows in is formed at an end in a longitudinal direction of each of the refrigerant flow passages 26, and an outlet 34 from which the refrigerant flows out is formed at the other end of the same. The inlet 32 and the outlet 34 are in communication with each other via a space defined inside the respective refrigerant flow passages 26.

The supply header portion 28 is made of aluminum. The supply header portion 28 includes a supply header body portion 36 and supply header communication tubes 38. Each of the supply header communication tubes 38 has a cylindrical shape with a short axis. Each of the supply header communication tubes 38 is connected to refrigerant flow passages 26 adjacent to each other in the stacking direction. More specifically, each of the supply header communication tubes 38 is connected to such refrigerant flow passages 26 so as to cover the inlets 32 of such refrigerant flow passages 26. A total of four supply header communication tubes 38 are arranged along a straight line in the stacking direction.

The supply header body portion 36 has a cylindrical shape with an axis longer than that of the supply header communication tubes 38. The supply header body portion 36 is provided along the same straight line as that along which the supply header communication tubes 38 are arranged, so as to extend from a stack including the semiconductor modules 20 and 22 and the refrigerant flow passages 26 toward the one side in the stacking direction. An end of the supply header body portion 36 is connected to the refrigerant flow passage 26 positioned at an end portion on the one side in the stacking direction, so as to cover the inlet 32 of such refrigerant flow passage 26. Another end of the supply header body portion 36 is connected to a radiation device (not illustrated). Furthermore, the supply header body portion 36 is secured to a housing (not illustrated) that houses the stacked cooler 24.

The discharge header portion 30 is made of aluminum. The discharge header portion 30 includes a discharge header body portion 40 and discharge header communication tubes 42. Each of the discharge header communication tubes 42 has a cylindrical shape with a short axis. Each of the discharge header communication tubes 42 is connected to refrigerant flow passages 26 adjacent to each other in the stacking direction. More specifically, each of the discharge header communication tubes 42 is connected to such refrigerant flow passages 26 so as to cover the outlets 34 of such refrigerant flow passages 26. A total of four discharge header communication tubes 42 are arranged along a straight line in the stacking direction.

The discharge header body portion 40 has a cylindrical shape with an axis longer than that of the discharge header communication tubes 42. The discharge header body portion 40 is provided along the same straight line as that along which the discharge header communication tubes 42 are arranged, so as to extend from the stack including the semiconductor modules 20 and 22 and the refrigerant flow passages 26 toward the one side in the stacking direction. An end of the discharge header body portion 40 is connected to the refrigerant flow passage 26 positioned at an end portion on the one side in the stacking direction, so as to cover the outlet 34 of such refrigerant flow passage 26. The other end of the discharge header body portion 40 is connected to the radiation device (not illustrated). Furthermore, the discharge header body portion 40 is secured to the housing (not illustrated) that houses the stacked cooler 24.

The refrigerant flow passages 26, and the supply header portion 28 and the discharge header portion 30 are joined by joining respective joining parts thereof by means of brazing or swaging. Then, each of the semiconductor modules 20 and 22 is arranged between refrigerant flow passages 26 adjacent to each other in the stacking direction, and the stack including the semiconductor modules 20 and 22 and the refrigerant flow passages 26 is pressed from its opposite outer sides in the stacking direction at a predetermined pressure, whereby the semiconductor modules 20 and 22 are held by the refrigerant flow passages 26. More specifically, as a result of the pressing at the predetermined pressure, the supply and discharge header communication tubes 38 and 42 are subjected to plastic deformation so that the supply and discharge header communication tubes 38 and 42 shorten in the stacking direction, whereby their distances to their respective adjacent refrigerant flow passages 26 are reduced, enabling the semiconductor modules 20 and 22 and the refrigerant flow passages 26, which are perpendicular to the stacking direction, to be brought into close contact with one another at their respective stacking surfaces. Furthermore, when assembling the stack to the housing, as illustrated in FIG. 3, an elastically-deformed elastic member 44 is pressed against the refrigerant flow passage 26 positioned at the end portion on the one side in the stacking direction. The elastic member 44 is, for example, a plate spring. Resilience of the elastic member 44 maintains the close contact between the refrigerant flow passages 26 and the semiconductor modules 20 and 22.

Furthermore, preferably, when the stacked cooler 24 is housed in the housing, a refrigerant flow passage movement restriction portion (not illustrated) that restricts movement in the stacking direction of the refrigerant flow passage 26 positioned at an end portion on the other side in the stacking direction is connected to such refrigerant flow passage 26. The refrigerant flow passage movement restriction portion is a bracket that supports the stacked cooler 24, or an electronic component module that can be cooled by the refrigerant flow passage 26, such as a step-up converter. When the stacked cooler 24 is housed in the housing, the respective supply and discharge header body portions 36 and 40 are connected to the housing, and thus, restriction is imposed on movement of the supply and discharge header body portions 36 and 40 in the stacking direction.

A flow of a refrigerant in the stacked cooler 24 configured as described above will be descried by reference to FIG. 3. The description will be given in terms of a case where the power modules are operating and the semiconductor modules 20 and 22 are generating heat.

A refrigerant introduced from the non-illustrated radiator device to the supply header body portion 36 is supplied to the five refrigerant flow passages 26 directly or via the supply header communication tubes 38. The heat from the semiconductor modules 20 and 22 is transmitted to the refrigerant flowing in the refrigerant flow passages 26. The refrigerant whose temperature has increased upon receipt of the heat from the semiconductor modules 20 and 22 flows into the discharge header body portion 40 from the refrigerant flow passages 26 directly or via the discharge header communication tubes 42. The refrigerant merged in the discharge header body portion 40 is supplied to the radiator device and cooled therein. Then, the refrigerant cooled in the radiator device is introduced again to the supply header body portion 36.

As described above, the output characteristic of the MG2 is larger than the output characteristic of MG1, and thus, an amount of heat generated by the second inverter 16b for MG2 is larger than an amount of heat generated by the first inverter 16a for MG1. In such case, in order to cool two inverters that generate different amounts of heat, conventional stacked coolers require cooling capability for cooling semiconductor modules belonging to the inverter that generates a largest amount of heat (corresponding to the second inverter 16b in the present embodiment). However, such cooling capability is excessive for semiconductor modules belonging to the inverter that generates a small amount of heat (corresponding to the first inverter 16a in the present embodiment).

Therefore, in the present embodiment, the semiconductor modules 20 and 22 are arranged in respective arrangement spaces in which the electronic components are arranged adjacent to the refrigerant flow passages 26, and such arrangement is made so that a difference in amount of heat generated by the semiconductor module(s) between the respective arrangement spaces becomes small. More specifically, three semiconductor modules 22 and a semiconductor module 20 are arranged sequentially from the one side to the other side in the stacking direction. Where a plurality of semiconductor modules are arranged in one arrangement space, arrangement may be made so that a difference between a total amount of heat generated by the semiconductor modules in such arrangement space, as well as an amount of heat generated in each of other arrangement spaces, is small.

Since the semiconductor module in the second inverter 16b has been divided into three, the amount of heat generated in the second inverter 16b is dispersed, enabling a difference in amount of heat generated between the arrangement spaces to be small. Consequently, it is possible to prevent the stacked cooler 24 from having excessive cooling capability meeting that required for one of the inverters. Furthermore, even though the semiconductor module in the second inverter 16b has been divided into three, such semiconductor modules are arranged sequentially in the stacking direction, enabling prevention of complication of electrical connection to a respective device to be controlled (MG2), and also enabling prevention of increase in size of the body of the stacked cooler 24 due to the complication.

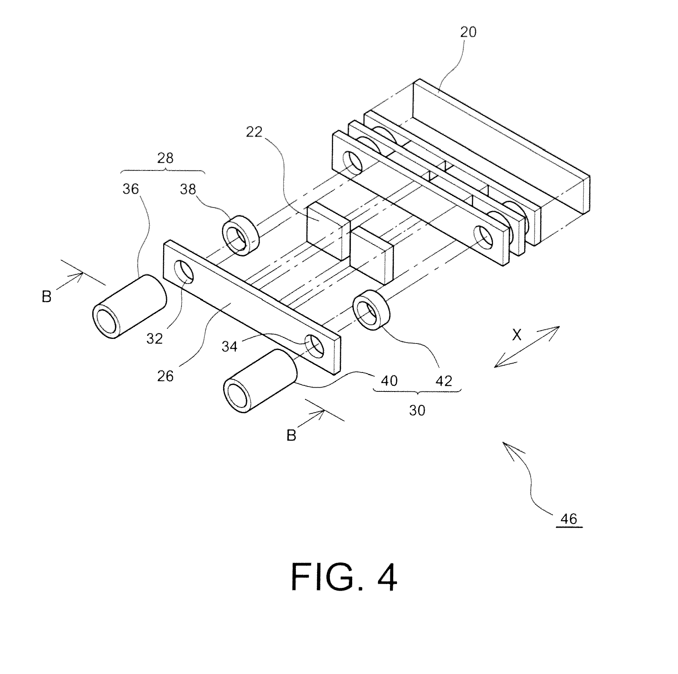

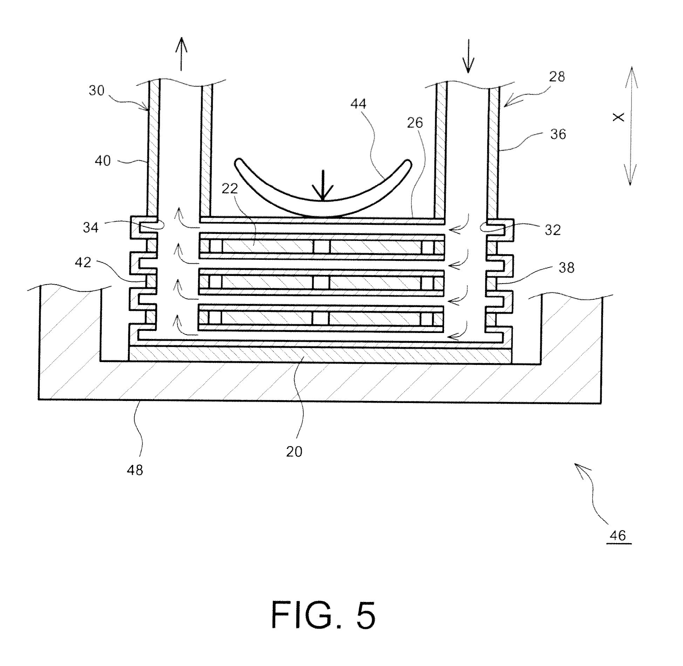

Next, a stacked cooler 46 according to another embodiment will be described by reference to FIGS. 4 and 5. FIG. 4 is an exploded perspective diagram of a stacked cooler 46 according to another embodiment, and FIG. 5 is a sectional view of the stacked cooler 46 along line B-B in FIG. 4. Here, components that are the same as those in the above-described embodiment are provided with reference numerals that are identical to those of the above-described embodiment, and detailed description thereof will be omitted.

Since a semiconductor module 20 is a 6-in-1 module, the semiconductor module 20, when projected in a stacking direction, is larger than a semiconductor module 22, which is a 2-in-1 module. With respect to this sort of semiconductor module 20, refrigerant flow passages 26 are formed so as to, when projected in a stacking direction, cover an outline of the semiconductor module 20. In other words, the semiconductor module 20, when projected in the stacking direction, is smaller than the refrigerant flow passages 26. Furthermore, the semiconductor module 20 is preferably larger than a distance between supply and discharge header portions 28 and 30 in a longitudinal direction of the refrigerant flow passages 26; in other words, a width direction of the stack. The semiconductor module 20 having such shape is arranged further on the outer side relative to a refrigerant flow passage 26 positioned on another end side in the stacking direction.

In the stacked cooler 46 according to the present embodiment, each of the semiconductor modules 22 is arranged between respective refrigerant flow passages 26 adjacent to each other in the stacking direction, and the semiconductor module 20 is arranged further on the outer side relative to a refrigerant flow passage 26 positioned on the other end side in the stacking direction, and a stack including them is pressed from its opposite outer sides in the stacking direction at a predetermined pressure, whereby the semiconductor modules 20 and 22 and the refrigerant flow passages 26 are brought into close contact with one another at their respective stacking surfaces.

A housing 48 that houses the stacked cooler 46 is made of aluminum, and includes an engagement portion (not illustrated) for positioning the stack. As a result of the engagement portion and the stack being brought into contact with each other, a position of the stack inside the housing 48 is determined. The engagement portion includes, for example, a plurality of pins, and these pins are arranged so as to be in contact with an outer periphery of the stack. Also, the present invention is not limited to such configuration, and the engagement portion may include male screws, such as bolts that are inserted through the housing 48. In this case, female thread holes are formed in the semiconductor module 20, and the male screws are screwed into the holes, whereby a position of the stack inside the housing 48 is determined and the stack is reliably secured to the housing 48. Alternatively, the engagement portion may include holes. In this case, pins extending toward the other end side in the stacking direction are formed in the semiconductor module 20, and the pins are inserted into the engagement portion, whereby a position of the stack inside the housing 48 is determined.

Then, when assembling the stack to the housing 48, as illustrated in FIG. 5, an elastically-deformed elastic member 44 is pressed against a refrigerant flow passage 26 positioned at an end portion on the one side in the stacking direction. Resilience of the elastic member 44 maintains the close contact between the refrigerant flow passages 26 and the semiconductor modules 20 and 22. Here, a stacking surface of the semiconductor module 20 that faces a stacking surface of the semiconductor module 20 that is in contact with the refrigerant flow passage 26 is in close contact with the housing 48 that houses the stacked cooler 46.

In the stacked cooler 46 according to the present embodiment, the semiconductor module 20 is positioned at an end portion on the other side of the stack. In other words, no refrigerant flow passage 26 is provided on the other side of the semiconductor module 20. The semiconductor module 20 is configured so that one of the stacking surfaces of the semiconductor module 20 is in contact with the refrigerant flow passage 26 and another of the stacking surfaces is in contact with the housing 48. With such a configuration, the semiconductor module 20 is cooled by the refrigerant flow passage 26 and the housing 48. More specifically, heat from the semiconductor module 20 is transmitted to a refrigerant flowing in the refrigerant flow passage 26 and also to the housing 48. The heat transmitted to the housing 48 is released to the outside from an outer surface of the housing 48. Accordingly, cooling capability for the semiconductor module 20 can also be maintained. In the present embodiment, one of the stacking surfaces of the semiconductor module 20 is cooled by an air cooling method, which is inferior in cooling capability to a method using a refrigerant, and thus, an amount of heat generated by the semiconductor module 20 is preferably smaller than that of the semiconductor module 22.

The stacked cooler 46 according to the present embodiment enables reduction in size in the stacking direction of the body thereof as compared with the stacked cooler 24 according to the above-described embodiment, because no refrigerant flow passage 26 is provided on the other side relative to the semiconductor module 20. Furthermore, a refrigerant flow passage 26 is formed so as to cover the semiconductor module 20, enabling reduction in size in the width direction of the body of the stack as compared with that of the stacked cooler 24 according to the above-described embodiment. Furthermore, compared to the stacked cooler 24 according to the above-described embodiment, a refrigerant flow passage movement restriction portion has been eliminated and the number of refrigerant flow passages 26 is reduced, enabling reduction in cost and saving of trouble in the assembly process.

Although each of the embodiments has been described in terms of a case where the refrigerant flow passages 26, the supply header portion 28, the discharge header portion 30, and the housing 48 are made of aluminum, the present invention is not limited to such a configuration. Any material having good heat conductivity, such as copper, may be employed.

### REFERENCE SYMBOL LIST

10 hybrid vehicle, 12 battery, 14 converter, 16 inverter, 18 rotating electrical machine, 20, 22 semiconductor module, 24, 46 stacked cooler, 26 refrigerant flow passage, 28 supply header portion, 30 discharge header portion, 32 inlet, 34 outlet, 36 supply header body portion, 38 supply header communication tube, 40 discharge header body portion, 42 discharge header communication tube, 44 elastic member, 48 housing

## Claims

1. A stacked cooler including a plurality of refrigerant flow passages allowing a refrigerant to flow therein and a plurality of electronic components, the refrigerant flow passages and the electronic components being stacked alternately, a stacking surface in a stacking direction of each of the electronic components being in contact with a corresponding one of the refrigerant flow passages, thereby cooling the electronic components,
wherein the electronic components include a plurality of electronic components that generate different amounts of heat; and
wherein one or a plurality of the electronic components are arranged in each of arrangement spaces adjacent to the respective refrigerant flow passages so that a difference in total amount of heat generated by the one or the plurality of the electronic components between the respective arrangement spaces becomes small.

2. The stacked cooler according to claim 1,
wherein each electronic component is a semiconductor module including at least one semiconductor device that is a heat generator; and
wherein one or a plurality of the semiconductor modules is arranged in each of the arrangement spaces so that the difference in the total amount of heat generated becomes small.

3. The stacked cooler according to claim 2, wherein the one or the plurality of the semiconductor modules arranged in each of the arrangement spaces include a number of semiconductor devices corresponding to the total amount of heat generated.

4. The stacked cooler according to claim 2,
wherein the electronic components include an end-portion electronic component arranged between a housing that houses a body of the stacked cooler, and a refrigerant flow passage positioned at an end portion in the stacking direction; and
wherein one stacking surface in the stacking direction of the end-portion electronic component is in contact with the refrigerant flow passage, and another stacking surface of the end-portion electronic component is in contact with the housing, thereby cooling the end-portion electronic component.

5. The stacked cooler according to claim 4, wherein the end-portion electronic component includes a number of semiconductor devices, the number being larger than that of another of the electronic components.

6. The stacked cooler according to claim 5, wherein the end-portion electronic component, when projected in the stacking direction, is larger than the other electronic components.

7. The stacked cooler according to claim 6, wherein the end-portion electronic component, when projected in the stacking direction, is smaller than a refrigerant flow passage.

8. The stacked cooler according to claim 5, wherein the total amount of heat generated by the end-portion electronic component is smaller than the total amount of heat generated by the other electronic components.
